# EUROPEAN PATENT SPECIFICATION

(11) **EP 2 748 350 B1**
(45) Date of publication and mention of the grant of the patent: **21.01.2015**
(21) Application number: 11751866.2
(22) Date of filing: 25.08.2011
(51) Int. Cl.: C23C 14/04, C23C 16/04

(54) **PROTECTION OF EDGE EXCLUSION MASK SHIELDING**
SCHUTZ EINER MASKENABSCHIRMUNG MIT KANTENAUSSCHLUSS
PROTECTION D'UN ÉCRAN DE MASQUE D'EXCLUSION DE BORD

(43) Date of publication of application: 02.07.2014
(73) Proprietor: Applied Materials, Inc., Santa Clara, CA 95054 (US)
(72) Inventor: ZENGEL, Claus, 63785 Obernburg (DE); LINDENBERG, Ralph, 63654 Büdingen-Rinderbügen (DE); WURSTER, Harald, 63776 Mömbris (DE); HANSEN, Hauke, 63776 Mömbris (DE)
(74) Representative: Zimmermann & Partner
(86) International application number: PCT/EP2011/064669
(87) International publication number: WO 2013/026492

(56) References cited:
- US-A1- 2001 040 264
- US-A1- 2008 006 523
- US-B1- 6 773 562

## Description

### TECHNICAL FIELD OF THE INVENTION

Embodiments of the present invention relate to masking arrangements and/or masks for layer deposition and method of layer deposition utilizing masking arrangements and/or masks. Embodiments of the present invention particularly relate to edge exclusion masks and methods of depositing layers with an edge exclusion mask, specifically to masking arrangement for masking a substrate during layer deposition, apparatus for depositing a layer on a substrate, and method of depositing a layer over a substrate.

### BACKGROUND OF THE INVENTION

Several methods are known for depositing a material on a substrate. For instance, substrates may be coated by a physical vapor deposition (PVD) process, a chemical vapor deposition (CVD) process, a plasma enhanced chemical vapor deposition (PECVD) process etc. Typically, the process is performed in a process apparatus or process chamber, where the substrate to be coated is located. A deposition material is provided in the apparatus. A plurality of materials, but also oxides, nitrides or carbides thereof, may be used for deposition on a substrate.

Coated materials may be used in several applications and in several technical fields. For instance, an application lies in the field of microelectronics, such as generating semiconductor devices. Also, substrates for displays are often coated by a PVD process. Further applications include insulating panels, organic light emitting diode (OLED) panels, substrates with TFT, color filters or the like.

In coating processes, it may be useful to use masks, for instance, in order to better define the area to be coated. In some applications, only parts of the substrate should be coated and the parts not to be coated are covered by a mask. In some applications, such as in large area substrate coating apparatuses, it can be useful to exclude the edge of the substrate from being coated. With the exclusion of the edge, e.g. by an edge exclusion mask, it is possible to provide coating free substrate edges and to prevent a coating of the backside of the substrate. For examples, LCD TV layer deposition as one of many other applications, require a non-coated substrate edge. The above-described mask usually covers this area of the substrate. For example, document US2008006523 describes a top shield for shielding a shadow frame within a PVD chamber. The shadow frame will rest on a under shield when a susceptor is in a lowered position. The top shield may remain in a stationary position and at least partially shield the shadow frame to reduce the amount of material that may deposit on the shadow frame during processing. The top shield may be cooled to reduce the amount of fluxuation in temperature of the top shield and shadow frame during processing and/or during down time

However, in a material deposition process, the mask, which may be an edge exclusion mask, is also exposed to the deposition material due to the location of the mask in front of the substrate. The influences of the non-coated and coated masks can be complex and may depend upon the material to be deposited. Further, the coating of the edge exclusion mask, a mask in general or components of a masking arrangement including the mask, a mask support and other elements like protective shields, can incur higher maintenance requirements.

In view of the above, it is an object of the present invention to provide a mask, particularly an edge exclusion mask, a masking arrangement, a deposition apparatus having a mask, and a method of masking the edges of a substrate that overcome at least some of the problems in the art.

### SUMMARY OF THE INVENTION

In light of the above, a mask structure according to independent claim 1, an apparatus according to independent claim 7 and a method according to independent claim 9 are provided. Further aspects, advantages, and features of the present invention are apparent from the dependent claims, the description, and the accompanying drawings.

According to one embodiment, a masking arrangement for masking a substrate during layer deposition is provided. The masking arrangement includes a mask structure forming an aperture for exposing the substrate during a layer deposition, and a protection shield, which is provided adjacent to the masking structure, wherein the protection shield protects one or more portions of the masking arrangement from being coated during layer deposition, and wherein an interface is formed between the protection shield and the masking structure, and wherein the mask structure comprises a roof portion extending over the interface, and wherein the roof portion forms a gap with a portion of the protection shield.

According to another embodiment, an apparatus for depositing a layer on a substrate is provided. The apparatus includes a chamber adapted for layer deposition therein, and a masking arrangement within the chamber. The masking arrangement includes a mask structure forming an aperture for exposing the substrate during a layer deposition, and a protection shield, which is provided adjacent to the masking structure, wherein the protection shield protects one or more portions of the masking arrangement from being coated during layer deposition, and wherein an interface is formed between the protection shield and the masking structure, and wherein the mask structure comprises a roof portion extending over the interface, and wherein the roof portion forms a gap with a portion of the protection shield. The apparatus further includes a deposition source for depositing material forming the layer.

According to a further embodiment, a method of depositing a layer over a substrate is provided. The method includes masking a portion of the substrate with a mask, wherein a roof portion of a masking structure extending over an interface formed between the masking structure and a protection shield is facing a deposition source; and depositing material of the layer on the substrate, wherein a coating is provided on the masking structure and a further coating is provided on the protection shield such that the coating and the further coating are not in contact with each other.

### BRIEF DESCRIPTION OF THE DRAWINGS

So that the manner in which the above recited features of the present invention can be understood in detail, a more particular description of the invention, briefly summarized above, may be had by reference to embodiments. The accompanying drawings relate to embodiments of the invention and are described in the following:
- FIG. 1A: shows a mask structure as commonly used for masking an edge of a substrate;
- FIG. 1B: shows cross-sectional side view of a mask structure as shown in FIG. 1A;
- FIGS. 2A and 2B: show scenarios of layer deposition on elements of a common mask arrangement;
- FIG. 3: shows a cross-sectional side view of a portion of a masking arrangement for illustrating embodiments of a masking arrangement and a mask structure, such as an edge exclusion mask;
- FIG. 4: illustrates deposition of coating material on a masking arrangement according to embodiments described herein;
- FIG. 5: shows a yet further masking arrangement and a mask structure, such as an edge exclusion mask, illustrating embodiments described herein;
- FIGS. 6A and 6B: show views of an apparatus for depositing a layer of material on a substrate utilizing a mask structure according to embodiments described herein and showing a scenario where no substrate is loaded;
- FIG. 7: shows a flow chart illustrating a method for depositing material on a substrate according to embodiments described herein, wherein an edge exclusion mask is utilized.

### DETAILED DESCRIPTION OF EMBODIMENTS

Reference will now be made in detail to the various embodiments of the invention, one or more examples of which are illustrated in the figures. Within the following description of the drawings, the same reference numbers refer to same components. Generally, only the differences with respect to individual embodiments are described. Each example is provided by way of explanation of the invention and is not meant as a limitation of the invention. Further, features illustrated or described as part of one embodiment can be used on or in conjunction with other embodiments to yield yet a further embodiment. It is intended that the description includes such modifications and variations.

According to some embodiments, a mask structure or an "edge exclusion mask" should be understood as a mask which covers at least an edge of the substrate to be coated. Generally, a mask may be composed of several parts or portions, which can form a frame, which defines one or more apertures. The frame of a mask may again have several frame portions or frame parts. According to some embodiments, the term "mask" is used for a piece of mask material, such as Invar, a carbon fiber material or a metal like aluminum, titan, stainless steel or the like. The mask covers a part of the substrate to be coated. Typically, the mask is located between the substrate to be coated and the source of the deposition material, such as a crucible, a target or the like.

Typically, an edge exclusion mask may cover from about 1‰ to about 5% of the area of the substrate, typically between about 5‰ to about 1% and even more typically between about 1% and about 2% of the area of the substrate. According to some embodiments, the area of the substrate covered, shadowed or masked by the edge exclusion mask is located at the periphery of the substrate.

An edge exclusion mask is desirable when the edge of a substrate should be kept free or substantially free from deposition material. This may be the case when only a defined area of the substrate should be coated due to the later application and/or handling of the coated substrate. For instance, a substrate which will be used as a display part, should have predefined dimensions. Typically, large area substrates are coated using an edge exclusion mask in order to shadow the edge of the substrate and/or to prevent backside coating of the substrate. This approach allows for reliable, constant coating on substrates.

According to some embodiments, large area substrates may have a size of typically about 1.4 m² to about 8 m², more typically about 2 m² to about 9 m² or even up to 12 m². Typically, the rectangular substrates, for which the mask structures, apparatuses, and methods according to embodiments described herein are provided, are large area substrates as described herein. For instance, a large area substrate can be GEN 5, which corresponds to about 1.4 m² substrates (1.1 m x 1.25 m), GEN 7.5, which corresponds to about 4.29 m² substrates (1.95 m x 2.2 m), GEN 8.5, which corresponds to about 5.7m² substrates (2.2 m x 2.5 m), or even GEN 10, which corresponds to about 8.7 m² substrates (2.85 m x 3.05 m). Even larger generations such as GEN 11 and GEN 12 and corresponding substrate areas can similarly be implemented.

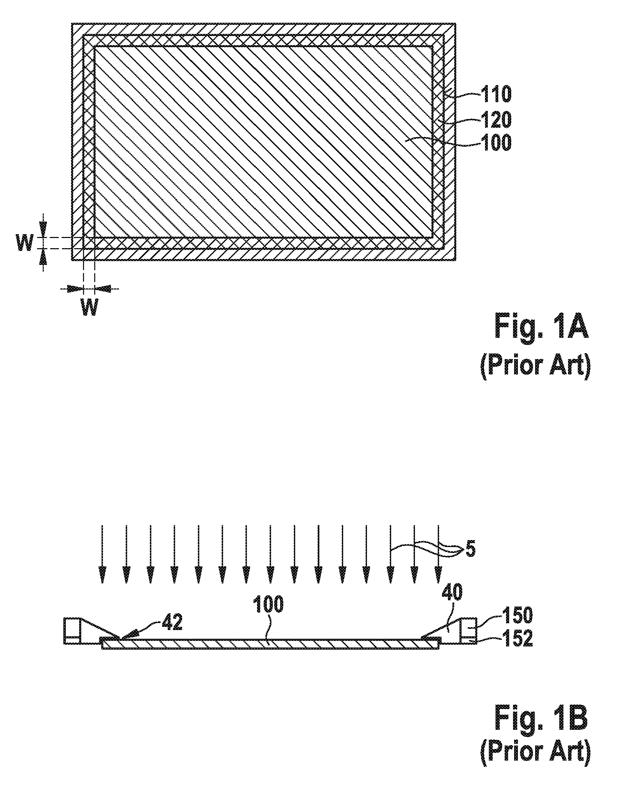

FIG. 1A shows an example of a substrate in rectangular shape. An outermost border of the substrate is denoted with 110. Typically, the border 110 may also be described as the outermost line of the substrate, beyond which the material of the substrate ends.

As used herein and according to some embodiments, an edge 120 of the substrate may contain the periphery of the substrate. Typically, the edge 120 as used herein may be an area containing the border 110 of the substrate. The edge 120 may have a width w, which extends on the surface of the substrate 100 from the border 110. This edge 120 is typically defined on a processed substrate by the edge exclusion mask 40, which is utilized during deposition of one or more layers on the substrate 100.

FIG. 1B illustrates a side view of a substrate 100, and wherein the edge of the substrate is shadowed by a mask 40. The mask typically is provided to have a gap 42 of 2 mm to 8 mm from the substrate, i.e. the portion of the mask shadowing the substrate surface is not in contact with the substrate surface. According to other embodiments, the mask can also be in direct contact with the substrate, e.g. there can be no gap or the gap can be from 0 mm to 8 mm.

According to embodiments described herein, there can be a further cover 150, which prevents portions of the carrier or other portions of the masking structure such as a masking arrangement support element 152 to be coated with material during deposition of the material on the substrate.

The portions (40, 150, 152) of the masking arrangement can have a labyrinth structure (not shown), such that the cross-section shown in FIG. 1B has recesses and protrusion corresponding to each other at the adjacent elements of the masking arrangement. The one or more recesses and one or more protrusions at adjacent elements, i.e. neighboring elements in FIG. 1B, which form a labyrinth structure can reduce the amount of material, which is applied between the elements during deposition. The arrows 5 in Fig. 1A illustrate coating material to be deposited during deposition.

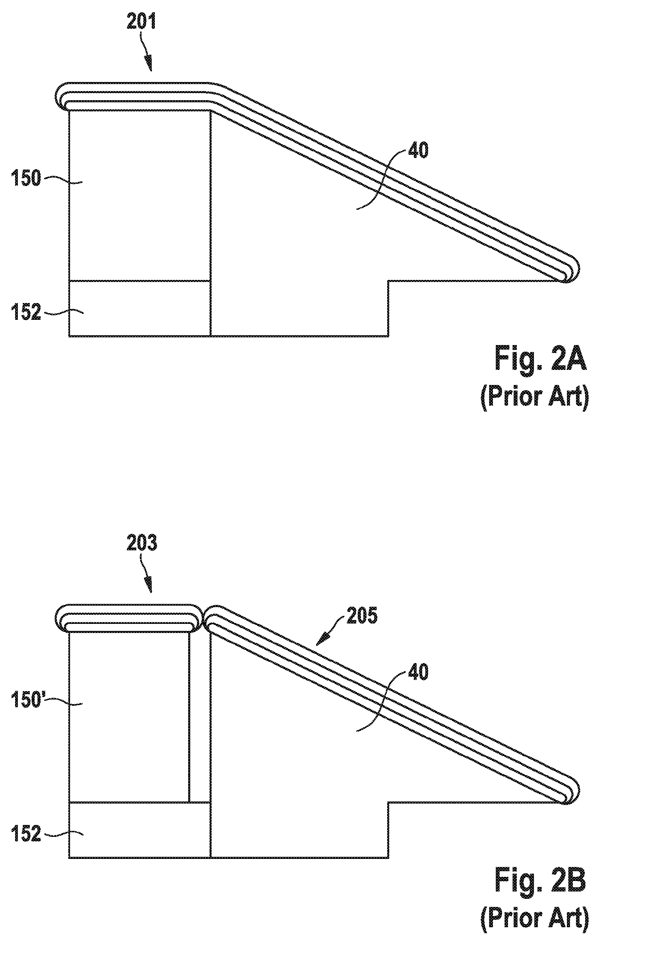

FIGS. 2A and 2B illustrate different problems that might occur with masking arrangements having a mask 49, a support 152 and a shield 150 as shown in FIGS. 1A to 2B. As shown in FIG. 2A, the mask 40 and the shield 150 can be directly adjacent to each other, i.e. there is essentially no gap between these elements of the masking arrangement. During deposition, as for example illustrated with arrows 5 in FIG. 1B, the elements of the masking arrangement are also subject to coating. This is illustrated by layer 201 in FIG. 1A, wherein the lines indicates the growths of deposition material on the mask 40 and the shield 150. Without a gap, the mask and the shield are covered with a continuous layer 201 after one or more deposition processes. This layer 201 results in a sticking together of the mask 40 and the shield 150. Accordingly, during maintenance increased effort needs to be provided to separate the masking arrangement elements, e.g. for separate cleaning or the like.

As shown in FIG. 2B, the mask 40 and the shield 150 can be provided adjacent to each other with a gap. During deposition, as for example illustrated with arrows 5 in FIG. 1B, the elements of the masking arrangement are also subject to coating. The mask 40 and the shield 150 are each subjected to be provided with a separate coating 203 and 205 respectively. These coatings grow during layer deposition and will generally grow to an extent where coating 203 and coating 205 are in contact with each other. Upon contact of coating 203 and coating 205, vibrations or other acceleration of the masking arrangement, e.g. during masking of a substrate in a carrier, result in particle generation from the coatings 203 and 205 based on friction between the two coatings. The particle generation can not be controlled such that there is a likelihood that undesired particles are also applied to a substrate surface to be processed. Accordingly, the design of the masking arrangement and particularly of the components mask and shield, which are adjacent to each other, can result in undesired effects during maintenance and/or during the processing of substrates.

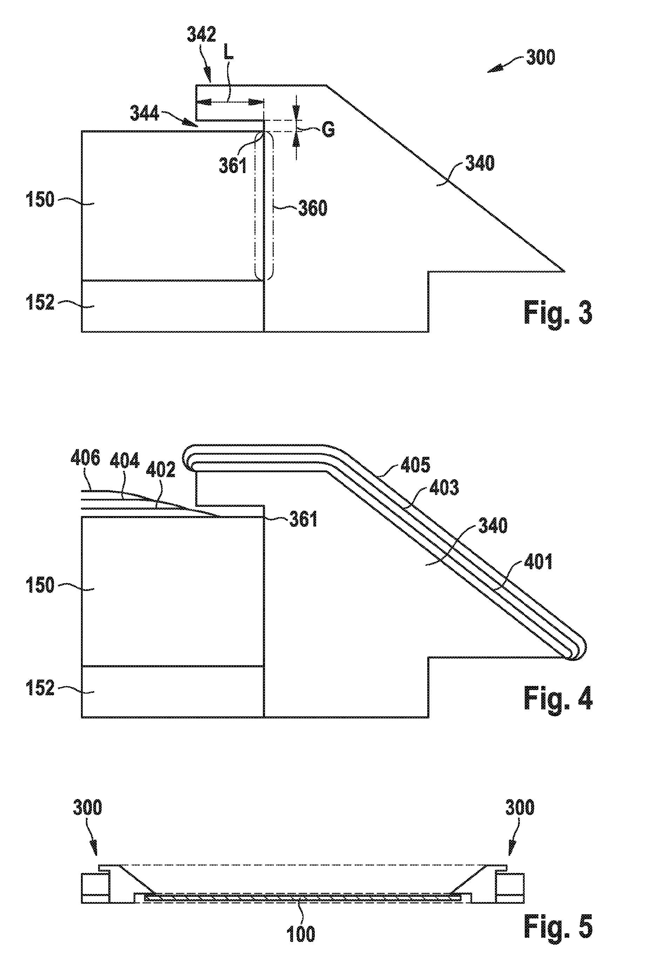

A cross section of one side of a masking arrangement, which typically forms a frame around a large area substrate or other substrates, is shown in FIG. 3 for illustration of embodiments described herein. The masking arrangement 300 includes a mask 340, e.g. an edge exclusion mask. Adjacent to the mask 340 shield 150 is provided. The shield can be configured to protect other portions of the masking arrangement from being coated during layer deposition. For example, the protection shield 150 can protect the support 152 of the masking arrangement from being coated during layer deposition on a substrate. In order to avoid deposition between single parts of the masking arrangement or continuous deposition of two or more parts of the masking arrangement, a roof portion 342 is provided. Typically, the roof portion can be integrally formed with mask 140. However this is not necessarily the case.

According to embodiments described herein, the roof portion 342 extends over the interface between the mask and the neighboring shield. The roof portion forms a gap 344 with a portion of the protection shield. As described herein, the interface 360 defines the area where the mask, e.g. the edge exclusion mask, and the adjacent component of the masking arrangement, e.g. the protection shield, face each other. In the cross section, this area is highlighted with a dashed ellipse, which does not form a portion of the arrangement but is for illustrative purposes only. It is to be understood that for a frame-shaped masking arrangement the interface extends along the shape of the frame, e.g. in a rectangular manner for a rectangular frame for rectangular substrates, in a circular manner for a circular frame for round substrates, or the like.

According to some embodiments described herein, the portions of the masking arrangement can have a labyrinth structure (not shown), such that the cross-section shown in FIG. 3 has one or more recesses and one or more protrusions corresponding to each other at the adjacent elements of the masking arrangement. The one or more recesses and one or more protrusions at adjacent elements, i.e. neighboring elements in FIG. 3, which form a labyrinth structure can reduce the amount of material, which is applied between the elements during deposition. Accordingly, the cross-sectional line illustrating the interfaces in FIG. 3, for example the line in dashed ellipse 360, does not need to be vertical and straight but could have vertical and horizontal portions forming recesses and protrusions in the respective elements of the masking arrangement.

According to embodiments described herein, the roof portion 342 can have a length L defined by the length at which the mask 340 extends over the shield 342. Typically, this length corresponds to the roof forming portion with respect to the line 361 of the interface facing the gap. According to typical embodiments, the roof portion extends over the line 361 by a dimension which is at least 2 times the gap width, particularly at least three time the gap width. According to yet further typical embodiments, the roof portion extends over the interface line by at least 7 mm, typically by about 8 mm to 24 mm.

The influence on "sticking" and "particle generation" of the roof portion can be better understood with respect to FIG. 4. Therein, the layer generation on the mask 340 and the shield 150 is illustrated. After a first period of deposition, layers 401 and 402 are formed over the mask 340 and the shield 150, respectively. The roof prevents coating material to cover the line 361 of the interface, i.e. the contact region or neighboring region of the mask and the shield. Typically, the layer 401 will be coated on the roof portion 342 such that the roof portion including the layer 401has a second length of extension over the interface, which is longer than the length L shown in FIG. 3, where no material is provided on the mask 340. Accordingly, a second period of deposition results in layers 403 and 404, wherein the layer 404 does not extend into the gap region to the same amount as layer 402 due to the "growth" of the roof portion based upon layer 401. The layer 403 will typically result in a further growth of the roof portion. That is the length of the roof including the layer is further increased. Thus, a third deposition period results in an even further coverage of the gap region, such that the layer 406 extends even less into the gap region. Further, the layer 405 results in a further growth of the roof portion, i.e. a further increased length. It is to be understood that even though FIG. 4 refers to three deposition periods resulting in three layers on each of the mask and the shield, this concept of self-shielding layers is a continuous process.

In light of the self-regulated shielding of the adjacent masking arrangement components, less deposition is provided on the contact area, i.e. the interface of these components. Thereby, a continuous layer resulting in "sticking" of the components can be avoided. Further, in light of the increasing length of the roof portion, the layer on the mask and the layer on the shield will not get in contact with each other. Thereby, disassembling of a mask, e.g. an edge exclusion, and protection shield, e.g., mask shieldings, is easier and faster as compared to existing systems. Product maintenance can be accelerate due to easier disassembling procedure. Further, an additional particle source due to relative movements between parts of the masking arrangement can be avoided.

According to different embodiments, which can be combined with other embodiments described herein, the mask frame can be made of materials like aluminum, Invar, titan and stainless steel.

Typically, the mask and the components of the masking arrangement 300 are formed as a frame, which is illustrated in Fig. 5, where the masking arrangement is provided on the substrate 100. For a rectangular substrate, the frame generally is rectangular as well, whereas for a round substrate the frame generally is round. The roof portion extends along the frame, i.e. along the line of the interface of the masking arrangement components, which faces the gap.

Typically, the width w (see FIG. 1) may be symmetrical for the whole substrate, i.e. each corner area and each side portion has the same width, but may also vary from side to side, depending on the application of the substrate. According to some embodiments, the edge of the substrate may be defined by the aperture of the mask used for coating the substrate. For instance, the aperture of an edge exclusion mask influences the area of the substrate which is coated and covers an area of the substrate such as the edge. Thus, the edge of a substrate may be defined as the area of the substrate which is covered by the edge exclusion mask and which is not coated during the coating process in which the edge exclusion mask is used.

Typically, the edge of a substrate may be defined as an area of the substrate which should be kept substantially free of deposition material or where the layer thickness of deposited material is reduced to a value of at least 25 % as compared to the un-masked substrate portion.

Typically, a substrate may be made from any material suitable for material deposition. For instance, the substrate may be made from a material selected from the group consisting of glass (for instance soda-lime glass, borosilicate glass etc.), metal, polymer, ceramic, compound materials, carbon fiber materials or any other material or combination of materials which can be coated by a deposition process.

According to some embodiments, the term "mask aperture" should be understood as a window of a mask, through which the deposition material may pass during the deposition process. Typically, the "mask aperture" may also be denoted as a coating window as it defines the area of the substrate on which coating material is deposited. The boundary or the inner boundary of the aperture is defined by the limitation of the coating window. For instance, if the mask is new or freshly cleaned and has not yet been used in a deposition process, the boundary of the aperture would consist of mask material. If the mask is used in a deposition process and deposition material is deposited on the mask, the boundary of the aperture may be the limitation of the coating window as provided by the deposited material on the mask.

According to different embodiments, an edge exclusion mask can be utilized for PVD deposition processes, CVD deposition process or combinations thereof. Thereby, the edge of the mask influences atoms, molecules, clusters in the vicinity thereof. These effects can be more complex as the "stream of material" can be affected by turbulences or the like and the edge cannot necessarily be regarding as a sharp cut-off edge.

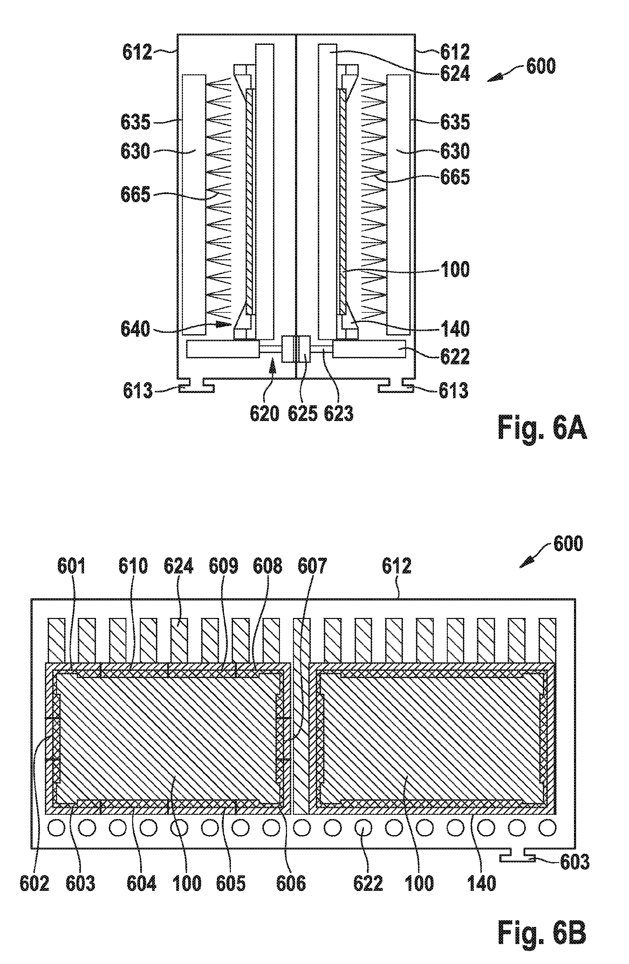

FIGS. 6A and 6B show schematic views of a deposition chamber 600 according to embodiments. The deposition chamber 600 is adapted for a deposition process, such as a PVD or CVD process. One or more substrates 100 is shown being located on a substrate transport device 620. According to some embodiments, the substrate support may be movable to allow adjusting the position of the substrate 100 in the chamber 612. Particularly for large area substrates as described herein, the deposition can be conducted having a vertical substrate orientation or an essentially vertical substrate orientation. Thereby, the transport device can have lower rollers 622, which are driven by one or more drives 625, e.g. motors. The drives 625 can be connected to a roller 622 by a shaft 623 for rotation of the roller. Thereby, it is possible that one motor 625 drives more than one roller, e.g. by connecting rollers with a belt, a gear system, or the like.

Rollers 624 can be used for support of the substrates in the vertical or essentially vertical position. Typically, the substrates can be vertical or can slightly deviate from the vertical position, e.g. up to 5°. Large area substrates having substrate sizes of 1 m² to 9 m² are typically very thin, e.g. below 1 mm, such as 0.7 mm or even 0.5 mm. In order to support the substrate and to provide the substrates with a fixed position, the substrates are provided in a carrier during processing of the substrates. Accordingly, the substrates can be transported by the transport system including, e.g., a plurality of rollers and drives while being supported in a carrier. For example, the carrier with the substrates therein is supported by the system of rollers 622 and rollers 624.

A deposition material source 630 is provided in chamber 612 facing the side of the substrate to be coated. The deposition material source 630 provides deposition material 635 to be deposited on the substrate. As shown in FIG. 6A and according to embodiments described herein, the source 630 may be a target with deposition material thereon or any other arrangement allowing material to be released for deposition on substrate 100. Typically, the material source 630 may be a rotatable target. According to some embodiments, the material source 630 may be movable in order to position and/or replace the source 630. According to other embodiments, the material source may also be a planar target.

According to some embodiments, the deposition material, which is indicated by reference numeral 635 during layer deposition, may be chosen according to the deposition process and the later application of the coated substrate. For instance, the deposition material of the source may be a material selected from the group consisting of: a metal, such as aluminum, molybdenum, titanium, copper, or the like, silicon, indium tin oxide, and other transparent conductive oxides. Typically, oxide-, nitride- or carbide-layers, which can include such materials, can be deposited by providing the material from the source or by reactive deposition, i.e. the material from the source reacts with elements like oxygen, nitride, or carbon from a processing gas. According to some embodiments, thin film transistor materials like siliconoxides, siliconoxynitrides, siliconnitrides, aluminumoxide, aluminumoxynitrides may be used as deposition material.

Typically, the deposition chamber 600 includes a masking arrangement 640 including a mask structure 140. According to some embodiments, the mask 140 is an edge exclusion mask. The edge exclusion mask 140 ensures that the edges of the substrate 100 are not coated with deposition material 635. Dashed lines 665 show exemplarily the path of the deposition material 635 during operation of the chamber 600. As an example, the material 635 is sputtered or can also be vaporized and dashed lines 665 show schematically the path of the sputtered material vapor of the deposition material 635 to the substrate 100. As can be seen in Fig. 6A by the dashed lines 665, an edge of the substrate 100 remains free of deposition material due to the edge exclusion mask 140. The roof portion of the mask avoids sticking of neighboring mask elements and particle generation due to friction of coating material on neighboring mask elements.

In Fig. 6B, the left edge exclusion mask is illustrated to include individual frame portions 601, 602, 603, 604, 605, 606, 607, 608, 609 and 610 which are connected to form the mask frame. Typically, a mask structure particularly for large are substrate, will be provided by at least 4 corner portions 601, 603, 606, and 608, which can be essentially L-shaped and which will include the corner area or at least a significant portion of the corner area, and by side portions, which connect the corner parts to form the mask frame. Typically, the frame portions 601-610 may be arranged in a tongue-and-groove arrangement. The tongue-and-groove arrangement provides fixed positions of the frame portions relatively to one another. Further, according to some embodiments described herein, the tongue-and-groove arrangements of the frame portions allow the movement of the frame portions away from each other. Typically, a tongue-and-groove arrangement enables the frame portions to slide away from each other without causing a gap through which deposition material could pass. For reasons of simplicity, only the left mask structure 140 is shown with portions 601-610. Similarly more than one or all mask structures in a processing system can be provided with more than one portion to form the mask frame.

According to typical embodiments, which can be combined with other embodiments described herein, the one or more chambers 612 can be provided as vacuum chambers. Thereby, the chambers are adapted for processing and/or coating the substrates in a vacuum environment. Typically, the pressure can be below 10 mbar, e.g. between 1x10-7 mbar and 1x10-1 mbar. Thus, the deposition system may include a pumping system (not shown), which can be connected to vacuum flanges 613, and capable of achieving a pressure within processing chamber 612 sufficiently low enough for enabling the deposition system to be operable for a particular application, such as a pressure of 1x10-7 mbar. The pressure during deposition, such as PVD processes, (i.e. deposition pressure) may be between 0.1 Pa and 1 Pa. For particular embodiments, e.g. PVD applications, wherein the processing gas includes argon and at least one of oxygen or nitrogen, the argon partial pressure may be between 0.1 Pa and 1 Pa, and the oxygen, hydrogen and/or nitrogen partial pressure may be between 0.1 Pa and 1 Pa. Typically, the pressure ranges for CVD applications can be about 2 orders of magnitude larger, particularly at the high pressure end of the ranges given above.

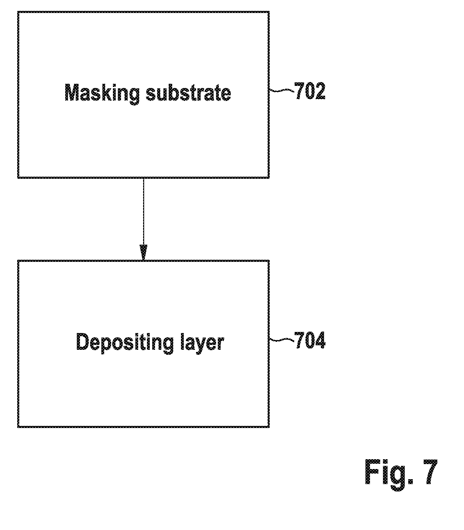

According to some embodiments, a method is provided for depositing a deposition material layer on a substrate. Fig. 7 shows a flow diagram of the described method. Typically, a substrate is provided in a chamber of a deposition apparatus. According to some embodiments, the substrate may be a large area substrate as described above and the deposition apparatus may be a deposition chamber as exemplarily shown in FIGS. 6A and 6B.

In step 702, a masking arrangement 640 (see, e.g. FIG. 6A) is moved towards the substrate within the chamber 612 and a portion of the substrate is covered by a mask. Typically, the mask covers an edge of the substrate. The masking is, according to embodiments described herein, provided with a roof portion edge exclusion mask as described herein. The mask typically provides an aperture which allows deposition material to pass through during a deposition process. After the masking of the substrate, a layer is deposited on step 704, such that the edge is kept free of or substantially free of deposited material. According to some embodiment, which can be combined with other embodiments described herein, the method for depositing material, deposition of the apparatus and the mask for covering an edge of the substrate are used for large area substrates.

Typically after the steps 702 and 704 have been conducted several times, the masking arrangement will be dissembled during a maintenance procedure. In light of the interface between adjacent masking arrangement components being substantially free of coating material, the masking arrangement can be more easily dissembled.

According to some embodiments, which can be combined with other embodiments described herein, the mask includes more than one frame portion to form the mask frame. Typically, the mask is adapted to be used in a deposition apparatus as described above.

In light of the above a plurality of embodiments are described. According to one embodiment, a masking arrangement for masking a substrate during layer deposition is provided. The masking arrangement includes a mask structure forming an aperture for exposing the substrate during a layer deposition, and a protection shield, which is provided adjacent to the masking structure, wherein the protection shield protects one or more portions of the masking arrangement from being coated during layer deposition, and wherein an interface is formed between the protection shield and the masking structure, and wherein the mask structure comprises a roof portion extending over the interface, and wherein the roof portion forms a gap with a portion of the protection shield. According to yet further embodiments, which can be combined with other embodiments described herein, the width of the gap can be at least 3 mm, typically from 4 mm to 8 mm; the roof portion can be configured to generate two separated coatings on the mask structure and on the protection shield, respectively, during layer deposition, wherein the two separate coatings are not in contact with each other; the roof portion can extend over a line of the interface facing the gap by a dimensions which is at least 2 times the gap width, typically at least three times the gap width; the roof portion can extend over the interface line by at least 7 mm, typically by about 8 mm to 24 mm; and/or the roof portion can extend along substantially the entire line of the interface between the mask structure and the protective shield facing the gap.

According to another embodiment, an apparatus for depositing a layer on a substrate is provided. The apparatus includes a chamber adapted for layer deposition therein, and a masking arrangement within the chamber. The masking arrangement includes a mask structure forming an aperture for exposing the substrate during a layer deposition, and a protection shield, which is provided adjacent to the masking structure, wherein the protection shield protects one or more portions of the masking arrangement from being coated during layer deposition, and wherein an interface is formed between the protection shield and the masking structure, and wherein the mask structure comprises a roof portion extending over the interface, and wherein the roof portion forms a gap with a portion of the protection shield. The apparatus further includes a deposition source for depositing material which forms the layer. According to yet further embodiments, which can be combined with other embodiments described herein, the apparatus can further include a transport system adapted for transportation of a carrier supporting the substrate.

According to a further embodiment, a method of depositing a layer over a substrate is provided. The method includes masking a portion of the substrate with a mask, wherein a roof portion of a masking structure extending over an interface formed between the masking structure and a protection shield is facing a deposition source; and depositing material of the layer on the substrate, wherein a coating is provided on the masking structure and a further coating is provided on the protection shield such that the coating and the further coating are not in contact with each other. According to yet further embodiments, which can be combined with other embodiments described herein, the roof portions can form a gap between the masking structure and the protective shield, wherein the gap is shaped to not be filled with the material during deposition; masking of the substrate can further include: transferring the substrate into a deposition chamber and moving a masking arrangement towards the substrate within the deposition chamber; and/or the method can further include removing the masking arrangement within the deposition chamber.

While the foregoing is directed to embodiments of the invention, other and further embodiments of the invention may be devised without departing from the basic scope thereof, and the scope thereof is determined by the claims that follow.

## Claims

1. A masking arrangement for masking a substrate during layer deposition; the masking arrangement comprising:
a mask structure forming an aperture for exposing the substrate during a layer deposition; and
a protection shield, which is provided adjacent to the masking structure, wherein the protection shield protects one or more portions of the masking arrangement from being coated during layer deposition, and wherein an interface is formed between the protection shield and the masking structure;
wherein the mask structure comprises a roof portion extending over the interface, and wherein the roof portion forms a gap with a portion of the protection shield.

2. The masking arrangement according to claim 1, wherein the width of the gap is at least 3 mm, typically from 4 mm to 8 mm.

3. The masking arrangement according to any of claims 1 to 2, wherein the roof portion is configured to generate two separated coatings on the mask structure and on the protection shield, respectively, during layer deposition, wherein the two separate coatings are not in contact with each other.

4. The masking arrangement according to any of claims 1 to 3, wherein the roof portion extends over a line of the interface facing the gap by a dimensions which is at least 2 times the gap width, typically at least three time the gap width.

5. The masking arrangement according to any of claims 1 to 4, wherein the roof portion extends over the interface line by at least 7 mm, typically by about 8 mm to 24 mm.

6. The masking arrangement according to any of claims 1 to 5, wherein the roof portion extends substantially along the entire line of the interface between the mask structure and the protections shield facing the gap.

7. An apparatus for depositing a layer on a substrate, comprising:
a chamber adapted for layer deposition therein,
a masking arrangement according to any of claims 1 to 6 within the chamber; and
a deposition source for depositing material forming the layer.

8. The apparatus according to claim 7, further comprising:
a transport system adapted for transportation of a carrier supporting the substrate.

9. A method of depositing a layer over a substrate, the method comprises:
masking a portion of the substrate with a mask, wherein a roof portion of a masking structure, which extends over an interface formed between the masking structure and a protection shield, is facing a deposition source; and
depositing material of the layer on the substrate, wherein a coating is provided on the masking structure and a further coating is provided on the protection shield such that the coating and the further coating are not in contact with each other.

10. The method according to claim 9, wherein the roof portion forms a gap between the masking structure and the protection shield and wherein the gap is shaped to not be filled with the material during deposition.

11. The method according to any of claims 9 to 10, wherein masking a portion of the substrate further includes:
transferring the substrate into a deposition chamber; and
moving a masking arrangement towards the substrate within the deposition chamber.

12. The method according to claim 11, further comprising:
removing the masking arrangement within the deposition chamber.

## Patentansprüche

1. Maskierungsanordnung zum Maskieren eines Substrats während einer Schichtabscheidung, wobei die Maskierungsanordnung umfasst:
eine Maskenstruktur, die eine Öffnung zum Freilegen des Substrats während einer Schichtabscheidung bildet; und
ein Schutzabschirmung, die angrenzend an die Maskierungsstruktur vorgesehen ist, wobei die Schutzabschirmung einen oder mehrere Abschnitt/e der Maskierungsanordnung davor schützt, während der Schichtabscheidung beschichtet zu werden, und wobei eine Grenzfläche zwischen der Schutzabschirmung und der Maskierungsstruktur gebildet ist;
wobei die Maskenstruktur einen Überdachungsabschnitt aufweist, der sich über die Grenzfläche erstreckt, und wobei der Überdachungsabschnitt einen Spalt mit einem Abschnitt der Schutzabschirmung bildet.

2. Maskierungsanordnung nach Anspruch 1, wobei die Breite des Spalts mindestens 3 mm, typischerweise 4 mm bis 8 mm beträgt.

3. Maskierungsanordnung nach einem der Ansprüche 1 bis 2, wobei der Überdachungsabschnitt dazu ausgelegt ist, während der Schichtabscheidung zwei separate Beschichtungen auf der Maskenstruktur bzw. auf der Schutzabschirmung zu erzeugen, wobei die zwei separaten Beschichtungen miteinander nicht in Kontakt sind.

4. Maskierungsanordnung nach einem der Ansprüche 1 bis 3, wobei sich der Überdachungsabschnitt über eine Linie der Grenzfläche dem Spalt zugewandt um eine Abmessung erstreckt, die mindestens die 2-fache Spaltbreite, typischerweise mindestens die 3-fache Spaltbreite beträgt.

5. Maskierungsanordnung nach einem der Ansprüche 1 bis 4, wobei sich der Überdachungsabschnitt um mindestens 7 mm, typischerweise um ca. 8 mm bis 24 mm über die Grenzflächenlinie erstreckt.

6. Maskierungsanordnung nach einem der Ansprüche 1 bis 5, wobei sich der Überdachungsabschnitt im Wesentlichen entlang der gesamten Linie der Grenzfläche zwischen der Maskenstruktur und der dem Spalt zugewandten Schutzabschirmung erstreckt.

7. Vorrichtung zum Abscheiden einer Schicht auf einem Substrat, Folgendes umfassend:
eine Kammer, die für eine Schichtabscheidung in sich angepasst ist,
eine Maskierungsanordnung nach einem der Ansprüche 1 bis 6 in der Kammer; und
eine Abscheidungsquelle zum Abscheiden von Material, das die Schicht bildet.

8. Vorrichtung nach Anspruch 7, darüber hinaus umfassend:
ein Transportsystem, das zum Transport eines das Substrat tragenden Trägers angepasst ist.

9. Verfahren zum Abscheiden einer Schicht über einem Substrat, wobei das Verfahren umfasst:
Maskieren eines Abschnitts des Substrats mit einer Maske, wobei ein Überdachungsabschnitt einer Maskierungsstruktur, der sich über eine Grenzfläche erstreckt, die zwischen der Maskierungsstruktur und einer Schutzabschirmung gebildet ist, einer Abscheidungsquelle zugewandt ist; und
Abscheiden von Material der Schicht auf dem Substrat, wobei eine Beschichtung auf der Maskierungsstruktur bereitgestellt wird, und eine weitere Beschichtung auf der Schutzabschirmung bereitgestellt wird, und zwar so, dass die Beschichtung und die weitere Beschichtung miteinander nicht in Kontakt sind.

10. Verfahren nach Anspruch 9, wobei der Überdachungsabschnitt einen Spalt zwischen der Maskierungsstruktur und der Schutzabschirmung bildet, und wobei der Spalt so gestaltet ist, dass er während der Abscheidung nicht mit dem Material gefüllt wird.

11. Verfahren nach einem der Ansprüche 9 bis 10, wobei das Maskieren eines Abschnitts des Substrats darüber hinaus umfasst:
Übertragen des Substrats in eine Abscheidungskammer; und
Bewegen einer Maskierungsanordnung zum Substrat in der Abscheidungskammer.

12. Verfahren nach Anspruch 11, darüber hinaus umfassend:
Entfernen der Maskierungsanordnung in der Abscheidungskammer.

## Revendications

1. Agencement de masquage destiné à masquer un substrat pendant un dépôt de couche ; l'agencement de masquage comprenant :
une structure de masque formant une ouverture destinée à exposer le substrat pendant un dépôt de couche ; et
un écran de protection, lequel est disposé de façon adjacente à la structure de masquage, l'écran de protection empêchant une ou plusieurs parties de l'agencement de masquage d'être recouvertes pendant le dépôt de couche, et une interface étant formée entre l'écran de protection et la structure de masquage ;
la structure de masque comprenant une partie toit s'étendant par-dessus l'interface, et la partie toit formant un espace avec une partie de l'écran de protection.

2. L'agencement de masquage selon la revendication 1, dans lequel la largeur de l'espace est d'au moins 3 mm, typiquement de 4 mm à 8 mm.

3. L'agencement de masquage selon l'une quelconque des revendications 1 à 2, dans lequel la partie toit est configurée pour générer deux revêtements séparés sur la structure de masque et sur l'écran de protection, respectivement, pendant le dépôt de couche, les deux revêtements séparés n'étant pas en contact l'un avec l'autre.

4. L'agencement de masquage selon l'une quelconque des revendications 1 à 3, dans lequel la partie toit s'étend par-dessus une ligne de l'interface faisant face à l'espace à raison d'une dimension qui est d'au moins deux fois la largeur d'espace, typiquement d'au moins trois fois la largeur d'espace.

5. L'agencement de masquage selon l'une quelconque des revendications 1 à 4, dans lequel la partie toit s'étend par-dessus la ligne d'interface à raison d'au moins 7 mm, typiquement à raison d'environ 8 mm à 24 mm.

6. L'agencement de masquage selon l'une quelconque des revendications 1 à 5, dans lequel la partie toit s'étend sensiblement le long de toute la ligne de l'interface entre la structure de masque et l'écran de protection faisant face à l'espace.

7. Dispositif destiné à déposer une couche sur un substrat, comprenant :
une chambre adaptée pour le dépôt de couche dans celle-ci,
un agencement de masquage selon l'une quelconque des revendications 1 à 6 à l'intérieur de la chambre ; et
une source de dépôt destinée à déposer de la matière formant la couche.

8. Le dispositif selon la revendication 7, comprenant en outre :
un système de transport apte à transporter un support supportant le substrat.

9. Procédé de dépôt d'une couche par-dessus un substrat, le procédé comprenant :
le masquage d'une partie du substrat avec un masque, sachant qu'une partie toit d'une structure de masquage, laquelle s'étend par-dessus une interface formée entre la structure de masquage et un écran de protection, fait face à une source de dépôt ; et
le dépôt de matière de la couche sur le substrat, sachant qu'un revêtement est disposé sur la structure de masquage et qu'un revêtement supplémentaire est disposé sur l'écran de protection de telle sorte que le revêtement et le revêtement supplémentaire ne soient pas en contact l'un avec l'autre.

10. Le procédé selon la revendication 9, dans lequel la partie toit forme un espace entre la structure de masquage et l'écran de protection et dans lequel l'espace est formé de manière à ne pas être rempli de matière pendant le dépôt.

11. Le procédé selon l'une quelconque des revendications 9 à 10, dans lequel le masquage d'une partie du substrat inclut en outre :
le transfert du substrat dans une chambre de dépôt ; et
le déplacement d'un agencement de masquage vers le substrat à l'intérieur de la chambre de dépôt.

12. Le procédé selon la revendication 11, comprenant en outre :
l'enlèvement de l'agencement de masquage à l'intérieur de la chambre de dépôt.
